# EUROPÄISCHE PATENTANMELDUNG

(11) **EP 1 424 883 A2**
(43) Veröffentlichungstag der Anmeldung: **02.06.2004**
(21) Anmeldenummer: 03104000.9
(22) Anmeldetag: 29.10.2003
(51) Int. Cl.: H05K 9/00, H01T 4/08

(54) **Anordnung zur Reduzierung der elektromagnetischen Abstrahlung und zur Ableitung von Überspannungen**

(30) Priorität: 27.11.2002 DE 10255337
(71) Anmelder: SIEMENS AKTIENGESELLSCHAFT, 80333 München (DE)
(72) Erfinder: Reinhardt, Jörg, 35633, Lahnau (DE)

(57) **Zusammenfassung**

Die Erfindung betrifft eine Anordnung zur Reduzierung der elektromagnetischen Abstrahlung und zur Ableitung von Überspannungen bei einer Leiterplatine (1), wobei mindestens ein leitender Bereich (2) der Leiterplatine (1) von einer Lötstoppschicht überdeckt ist. Erfindungsgemäß besteht die Lötstoppschicht aus einer Lötstoppfolie (3), die auf ihrer von der Leiterplatine abgewandten Seite mit einem leitfähigen Material beschichtet ist, welches als Flächenelement (4) ausgeführt ist.

## Beschreibung

Die Erfindung betrifft eine Anordnung zur Reduzierung der elektromagnetischen Abstrahlung und zur Ableitung von Überspannungen bei einer Leiterplatine, wobei mindestens ein leitender Bereich der Leiterplatine von einer Lötstoppschicht überdeckt ist.

Jedes elektronische Gerät bzw. jede elektronische Baugruppe strahlt aufgrund der elektrischen Leitungsvorgänge ein elektromagnetisches Feld ab. Dabei hängt das Frequenzspektrum des entstehenden Feldes von der Art und Geschwindigkeit der Leitungsvorgänge ab. In heutigen Geräten bewegen sich die Frequenzen aufgrund der hochfrequenten Schaltungsvorgänge im MHz- bis GHz-Bereich. Andere, in der Nähe befindliche elektronische Geräte können durch diese abgestrahlten Felder gestört werden, was unter dem Begriff "elektromagnetische Verträglichkeit" bekannt geworden ist. Um eine störende Wechselwirkung elektronischer Geräte möglichst gering zu halten, hat der Gesetzgeber deshalb Grenzwerte für die maximal zulässigen Abstrahlungsfeldstärken in den unterschiedlichen Frequenzbereichen festgelegt.

Üblicherweise wird die elektromagnetische Abstrahlung elektronischer Geräte und Baugruppen durch eine Abschirmung der Felder mittels leitender Flächen reduziert. Die leitenden Flächen können dabei an Gehäusewänden oder direkt auf den Leiterplatinen als großflächige Schirmleiterzüge ausgeführt sein.

Aus DE 19613587 C2 ist eine Anordnung bekannt, bei der die elektromagnetische Abstrahlung von Leiterkarten und IC's durch eine Abdeckung der Leiterzüge mit leitfähigen Streifen oder Flächenelementen blockiert wird. Die leitfähigen Streifen bestehen aus dünnen Metallplättchen und werden Brücken genannt. Sie sind im Abstand zu den Leiterzügen angeordnet und mindestens einer ihrer Eckpunkte ist mit dem Massesystem der zu den Leiterzügen gehörenden Baugruppe verbunden. Diese Brücken müssen einzeln für den jeweiligen abzudeckenden Bereich hergestellt werden, d.h. an ihre Geometrie und ihre Abmessungen werden sehr unterschiedliche Forderungen gestellt. Zusätzlich sollen die Brücken für eine automatische Bestückung geeignet sein. Ihre Konstruktion und Herstellung erfordern demnach einigen Aufwand, was wiederum die Kosten in die Höhe treibt. Der Abstand und damit die Isolierung zwischen den Leiterzügen und den darüber liegenden Brücken muss, sofern kein Lötstopplack vorhanden ist, durch Abstandsnoppen oder einen zusätzlich aufzubringenden Isolierüberzug gewährleistet werden. Wird Lötstopplack genutzt, so ist dessen Schichtdicke aufgrund der Viskosität des Lackes u.U. nicht ganz gleichmäßig. Wie in DE 196 13 587 C2 beschrieben, sollte der Abstand der Brücke zum Leiterzug jedoch einen maximalen Wert nicht überschreiten, da sonst die abschirmende Wirkung nicht in ausreichendem Maße erreicht werden kann.

Neben der elektromagnetischen Verträglichkeit muss bei der Herstellung elektronischer Geräte auch der Aspekt der Ableitung von Überspannungen berücksichtigt werden. Diese Überspannungen können durch von außen auf das Gerät aufgebrachte, elektrostatische Ladung entstehen und sich im Inneren der elektronischen Schaltung entladen, was zur Zerstörung ganzer Baugruppen führen kann. Um sich davor zu schützen, werden die Gehäuse elektronischer Geräte mit dem Massepotential verbunden, so dass Überspannungen direkt abgeleitet werden.

Überspannungen können jedoch nicht nur über das Gehäuse, sondern auch über Steckverbinder aufgebracht werden. Diese Überspannungen müssen dann intern abgeleitet werden, bevor sie elektronische Bauteile gefährden können. Dafür werden Sollentladestrecken an einer von den inneren Bauteilen entfernten Stelle vorgesehen. Die Spannungsfestigkeit einer solchen Sollentladestrecke ist niedriger als die der zu schützenden Bauteile. Überschreitet die von außen aufgebrachte Überspannung einen Grenzwert, wird die Sollentladestelle elektrisch leitend. Durch einen Entladevorgang wird dann die Überspannung gegen ein Bezugspotential, normalerweise Masse, abgeleitet.

Als Sollentladestrecken werden entweder elektrische Bauteile bzw. ganze Schutzschaltungen angebracht, die z.B. ZenerDioden oder Varistoren enthalten, oder es werden sogenannte Funkenstrecken vorgesehen, bei denen sich zwei durch eine isolierende Schicht getrennte leitende Bereiche gegenüberstehen, wobei einer der leitenden Bereiche mit dem Massepotential verbunden ist, um den Entladestrom dahin abzuleiten.

Aus DE 19601650 A1 ist eine Anordnung zum Schutz elektronischer Bauteile vor elektrostatischer Entladung bekannt, bei der die die Bauteile tragende Leiterplatine über eine Isolationsschicht mit einer Metallplatte stoffschlüssig verbunden ist. Die Funkenstrecke wird dadurch ausgebildet, dass in der Isolationsschicht eine Öffnung vorgesehen ist, und zwar so, dass zwischen einer Leiterbahn der Leiterplatine und der Metallplatte nur noch die dazwischen befindliche Luft als Isolierung wirkt. Bei einer Überspannung würde es zuerst an dieser Stelle zu einer Funkenbildung kommen, da hier die sogenannte Durchbruchspannung am niedrigsten ist. Die Funkenstrecke ist sinnvollerweise zwischen einem Steckverbinder des Gerätes und einem zu schützenden Bauteil angeordnet. Nachteilig an dieser Anordnung ist die auf einer Seite der Leiterplatine anzubringende Metallplatte, die nicht nur zusätzlichen Bauraum erfordert und das Gewicht der Anordnung erhöht, sondern auch das beidseitige Bestücken der Leiterplatine verhindert. Einseitig bestückte Leiterplatinen benötigen deutlich mehr Platz als beidseitig bestückte, da zum einen alle Bauteile nebeneinander angeordnet werden müssen und zum anderen mehr Leiterbahnen zur Verbindung der Bauteile benötigt werden und weniger Durchkontaktierungsstellen genutzt werden können. Das Aufbringen der Isolationsschicht und der Metallplatte erhöht außerdem den Herstellungsaufwand und damit die Kosten.

Aufgabe der Erfindung ist es, eine Anordnung zur Reduzierung der elektromagnetischen Abstrahlung und zur Ableitung von Überspannungen bei Leiterplatinen zu finden, die nur wenig Aufwand beim Entwurf erfordert, einfach an elektronischen Schaltungen angebracht werden kann, keine zusätzlichen Bauelemente benötigt und sowohl für ein- als auch beidseitig bestückte Leiterplatinen verwendbar ist.

Die Aufgabe wird dadurch gelöst, dass bei einer Leiterplatine die Lötstoppschicht aus einer Lötstoppfolie gebildet wird und dass die Lötstoppfolie auf ihrer von der Leiterplatine abgewandten Seite mit einem leitfähigen Material beschichtet ist, welches als Flächenelement ausgeführt ist.

Anstelle von Lötstopplack kann bei der Abdeckung von leitenden Bereichen auf Leiterplatinen Lötstoppfolie verwendet werden. Diese hat den Vorteil, dass sie über die gesamte Leiterplatinenfläche eine absolut gleichmäßige Schichtdicke aufweist. Damit kann der in Verbindung mit der DE 196 135 87 C2 beschriebene Nachteil von Lötstopplack - herabgesetzte Abschirmwirkung durch zu große Schichtdicken - von vornherein vermieden werden. Die leitfähige Beschichtung der Lötstoppfolie kann z.B. durch ein Bedrucken mit Karbon erfolgen. Die Gestaltung der Abschirmflächen auf der Lötstoppfolienoberfläche wird direkt beim Schaltungsentwurf gemeinsam mit dem Layout der Leiterplatine festgelegt, d.h. es können u.U. dieselben Layoutwerkzeuge genutzt werden. Das Aufbringen der leitfähigen Beschichtung auf die Folie ist der einzige wesentliche Arbeitsschritt, der bei der Herstellung zusätzlich erforderlich wird. Alle anderen Vorgänge bei der Leiterplatinenherstellung und -bestückung laufen wie gewohnt ab. Eine Bestückung mit zusätzlichen Bauteilen ist nicht notwendig.

Die Kontaktierung der leitfähigen Flächenelemente mit dem Massepotential kann im Zuge der Anbringung der Leiterplatine im Gerätegehäuse automatisch erfolgen, z.B. durch Verschraubung durch das Flächenelement hindurch.

Zur Abschirmung der aus den Leiterbahnen austretenden elektromagnetischen Felder ist es vorgesehen, dass ein Teil der Flächenelemente die Leiterbahnen großzügig überdecken. Zur Ableitung von Überspannungen werden unterhalb eines anderen Teils der leitfähigen Flächenelemente in die Lötstoppfolie Öffnungen eingebracht. An diesen Stellen entstehen in Verbindung mit den überdeckten Leiterbahnen Funkenstrecken, welche bei zu hohen Überspannungen durchschlagen und den Entladestrom über die Flächenelemente zum Massepotential hin ableiten.

Die Erfindung wird nachfolgend anhand von Ausführungsbeispielen und den Zeichnungen näher erläutert.
Es zeigen
- Fig. 1: einen Längsschnitt durch eine abzuschirmende Leiterbahn auf einer Leiterplatine mit darüber liegender, beschichteter Lötstoppfolie und Schraubverbindung zwischen Leiterplatine und Gerätegehäuse.
- Fig. 2: einen Schnitt durch eine Leiterplatine mit Steckerelement und einem vor Überspannung zu schützenden Bauteil sowie einer Funkenstrecke zwischen Steckerelement und Bauteil.

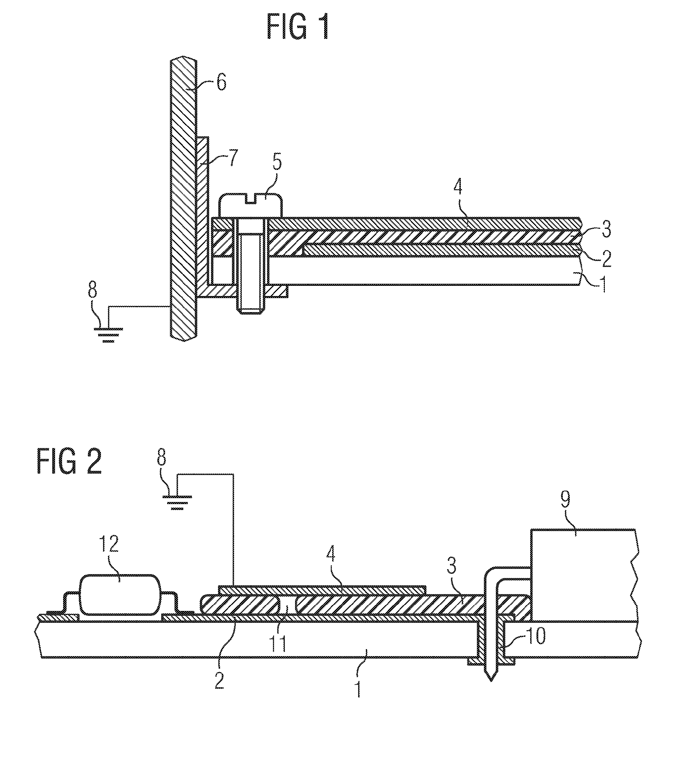

In Figur 1 ist ein Schnitt durch eine Leiterplatine 1 entlang einer Leiterbahn 2 dargestellt. Die Leiterbahn 2 ist durch eine Lötstoppfolie 3 abgedeckt, welche mit einem leitfähigen Flächenelement 4 beschichtet ist. Dieses Flächenelement 4 dient zur Abschirmung eines aus der Leiterbahn 2 austretenden elektromagnetischen Feldes. An ihrem Rand wird die Leiterplatine 1 durch eine Schraubverbindung 5 mit dem an der Gehäusewand 6 befestigten, leitenden Halterungsteil 7 verbunden. Das Halterungsteil 7 ist hier als Winkel dargestellt. Die Gehäusewand 6 ist mit dem Massepotential 8 verbunden. Da die Schraubverbindung 5 durch das Flächenelement 4 hindurchgeht und die Schraube selbst aus leitendem Material besteht, ist das Flächenelement 4 direkt mit dem Massepotential 8 verbunden.

Mit Figur 2 wird eine mögliche Ausführung zur Anbringung von Funkenstrecken verdeutlicht. Das Steckerelement 9 ist an der Kontaktierungsstelle 10 mit der Leiterbahn 2 leitend verbunden. In die mit dem Flächenelement 4 beschichtete Lötstoppfolie 3 wurde eine Öffnung 11 eingebracht. Das Flächenelement 4 ist mit dem Massepotential 8 verbunden. Wird über das Steckerelement 9 eine Überspannung aufgebracht, so kann sich diese über eine Funkenbildung an der Öffnung 11 entladen und gegen die Masse abfließen. Das Bauteil 12 wird damit vor dieser Überspannung geschützt.

## Patentansprüche

1. Anordnung zur Reduzierung der elektromagnetischen Abstrahlung und zur Ableitung von Überspannungen bei einer Leiterplatine (1), wobei mindestens ein leitender Bereich (2) der Leiterplatine (1) von einer Lötstoppschicht überdeckt ist, **dadurch gekennzeichnet, dass** die Lötstoppschicht aus einer Lötstoppfolie (3) gebildet wird und dass die Lötstoppfolie (3) auf ihrer von der Leiterplatine abgewandten Seite mit einem leitfähigen Material beschichtet ist, welches als Flächenelement (4) ausgeführt ist.

2. Anordnung nach Anspruch 1, **dadurch gekennzeichnet, dass** das Flächenelement (4) als Leiterbahn ausgebildet ist.

3. Anordnung nach Anspruch 1 oder 2, **dadurch gekennzeichnet, dass** das Flächenelement (4) mit einem Bezugspotential (8), insbesondere dem Massepotential, verbunden ist.

4. Anordnung nach Anspruch 3, **dadurch gekennzeichnet, dass** die Verbindung mit dem Bezugspotential (8) durch eine Schraubverbindung (5) hergestellt wird.

5. Anordnung nach einem der vorhergehenden Ansprüche, **dadurch gekennzeichnet, dass** das Flächenelement (4) aus Karbon besteht.

6. Anordnung nach einem der vorhergehenden Ansprüche, **dadurch gekennzeichnet, dass** eine Öffnung (11) unterhalb des Flächenelementes (4) angeordnet ist und der leitende Bereich (2) mit der in der Öffnung (11) befindlichen Luft und dem Flächenelement (4) eine Funkenstrecke zum Ableiten von Überspannungen bilden.

7. Lötstoppfolie (3), **dadurch gekennzeichnet, dass** mindestens eine Seite der Lötstoppfolie (3) mit einem leitfähigen Material beschichtet ist.
